# EUROPEAN PATENT APPLICATION

(11) **EP 2 273 549 A1**
(43) Date of publication of application: **12.01.2011**
(21) Application number: 10168897.6
(22) Date of filing: 08.07.2010
(51) Int. Cl.: H01L 23/58, H01L 23/00

(54) **Suppressing fractures in diced integrated circuits**

(30) Priority: 08.07.2009 US 499546
(71) Applicant: Lsi Corporation, Milpitas, California 95035 (US)
(72) Inventor: Bachman, Mark A., Sinking Springs, PA 19608 (US); Osenbach, John W., Kutztown, PA 19530 (US)
(74) Representative: Williams, David John

(57) **Abstract**

A semiconductor device has a singulated die (110a,110b) having a substrate (210) and a die edge. An interconnect dielectric layer (220) is located on the substrate, and integrated circuit has interconnections (230) located within the interconnect dielectric layer (220). A trench (250) is located in the interconnect dielectric layer (220) and between a seal ring (270) and a remnant (260) of the interconnect dielectric layer. The seal ring (270) is located within the interconnect dielectric layer (220) and between the trench (250) and the integrated circuit, with the remnant (260) of the interconnect dielectric layer being located between the trench (250) and the edge of the die.

## Description

### TECHNICAL FIELD

This application is directed, in general, to integrated circuits (ICs), and, more specifically, to singulating IC dies.

### BACKGROUND

Low-k and ultra low-k dielectrics and copper metallization are used for improved performance in leading edge silicon technologies. Although they provide lower dielectric constant and resistivity, respectively, a stack of copper interconnects and such dielectrics may be mechanically weak. Such weakness results from a lower fracture toughness of low-k and ultra low-k dielectrics relative to silicon dioxide and fluorine-doped silicon dioxide, as well as a reduction in the adhesion strength between different layers of dielectric and between the dielectric and copper. These characteristics may lead to significant yield loss and early failure of ICs using low-k dielectrics.

To ameliorate these issues, it is common practice to add a reinforcement structure around the edge of an IC die, referred to as a seal ring. The seal ring acts both to redistribute loads resulting from assembly and thermal mechanical stresses, and to reduce penetration of edge defects from propagating into the active area of the IC.

### SUMMARY

One aspect provides a semiconductor device that includes a singulated die having a substrate and a die edge. An interconnect dielectric layer is located on the substrate. An integrated circuit has interconnections located within the interconnect dielectric layer. A trench and a seal ring are located within the interconnect dielectric layer, with the seal ring being located between the trench and the integrated circuit. A remnant of the interconnect dielectric layer is located between the trench and the die edge.

Another aspect is a semiconductor wafer having a plurality of integrated circuits formed thereover. An interconnect dielectric layer is located over the wafer. Integrated circuits have respective interconnections within the interconnect dielectric layer. Seal rings are located within the dielectric layer and between the integrated circuits. Trenches located within the interconnect dielectric layer are located between the seal rings.

Another aspect is a method of forming an integrated circuit die. The method includes providing a wafer having a first integrated circuit located on a substrate and a second integrated circuit located on the substrate. A scribe street is located between the first and second integrated circuits. The first and second integrated circuits include an interconnect dielectric layer. A first seal ring is located within said interconnect dielectric layer and between said first integrated circuit and said scribe street. A second seal ring is located within said interconnect dielectric layer and between said second integrated circuit and said scribe street. A first and a second trench are formed in the interconnect dielectric layer such that the first seal ring is located between the first trench and the first integrated circuit, the second seal ring is located between the second trench and the second integrated circuit, and a dielectric strip is located between the first trench and the second trench.

### BRIEF DESCRIPTION

In accordance with the standard practice in the semiconductor industry, various features of the accompanying drawings may not be drawn to scale. In fact, the dimensions of the various features may be arbitrarily increased or reduced for clarity of discussion. Reference is now made to the following descriptions taken in conjunction with the accompanying drawings, in which:
FIG. 1 illustrates a semiconductor wafer with unsingulated integrated circuit dies of the disclosure formed thereon;
FIGs. 2A and 2B illustrate a plan view and sectional view, respectively, of a single integrated circuit die of FIG. 1;
FIG. 3 is a method of the disclosure for forming an integrated circuit;
FIG. 4 illustrates integrated circuits formed over a substrate;
FIG. 5 illustrates pattern and etch of a trench;
FIG. 6 illustrates the trench formed in the interconnect dielectric layer;
FIG. 7 illustrates two dies after singulating the devices; and
FIG. 8 illustrates a packaged die.

### DETAILED DESCRIPTION

In some circumstances, the seal ring structure does not prevent propagation of an edge defect. For example, ICs are typically separated in a process referred to as singulation. One method of singulation uses a wafer saw process, e.g. a spinning abrasive wheel, to remove a portion of a substrate (e.g. a wafer) and overlying layers in a dicing street between integrated circuit dies being separated. The stress produced by the saw blade on the substrate, and dielectric and metal layers formed on the substrate sometimes results in a defect that propagates through the seal ring. The defect may lead to immediate yield loss or may result in premature failure of the electronic device.

Embodiments herein reflect the recognition that the propagation of defects that are initiated during singulation may be arrested by the formation of a dielectric-free region between the dicing street and the seal ring. When a defect forms, it may propagate to the region. However, propagation of the defect is inhibited by the absence of dielectric therein.

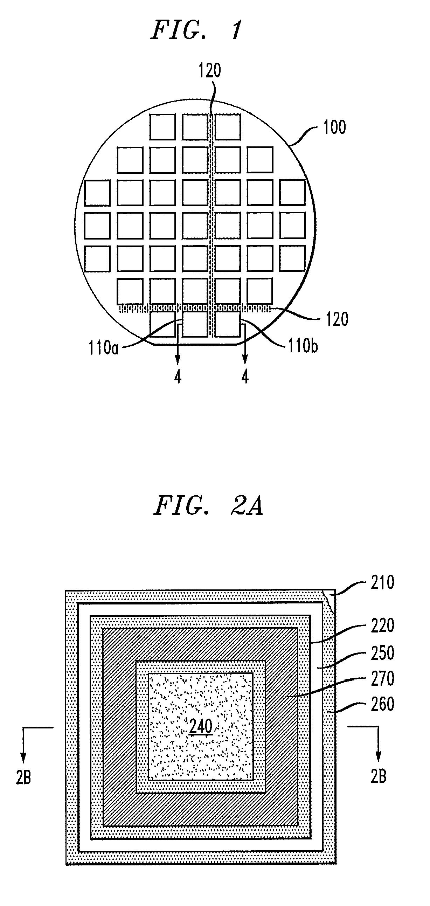

Turning first to FIG. 1, illustrated is a wafer 100 having a plurality of unsingulated dies 110 formed thereon. Two dies 110a, 110b are indicated for reference in the discussion below. Each die 110 is typically an instance of a nominally identical electronic device as described further below. Between each die 110 are dicing streets 120. A vertical and horizontal dicing street 120 are highlighted for reference. Among other things, the dicing streets 120 provide space between the dies 110 to remove a portion of the wafer 100 in the singulation process. The dies 110 are typically arranged in a rectilinear array for ease of singulation, but embodiments herein are not so limited. Usually, the dies 100 are singulated by a conventional wafer saw operation. In such a process a wafer saw blade cuts through the wafer 100, including any dielectric or metal layers located thereover, in a path within the dicing streets 120. Alternatively, a laser singulation process may be used. Embodiments of the disclosure are not limited to any particular means of singulation.

The wafer 100 may be any rigid substrate suitable to support manufacturing the dies 110. For instance, the wafer 100 may be or include any elemental or compound semiconductor material, such as Si, Ge, InP, GaAs, or CdTe. The wafer 100 may also be or include a non-semiconducting material, such as crystalline sapphire, alumina, silica or aluminum nitride. In some cases, the wafer 100 may be or include a glass, such as a semiconductor-glass composite. In some cases, the wafer 100 may include an epitaxial layer formed over a "handle" wafer, wherein transistors are formed in the epitaxial layer.

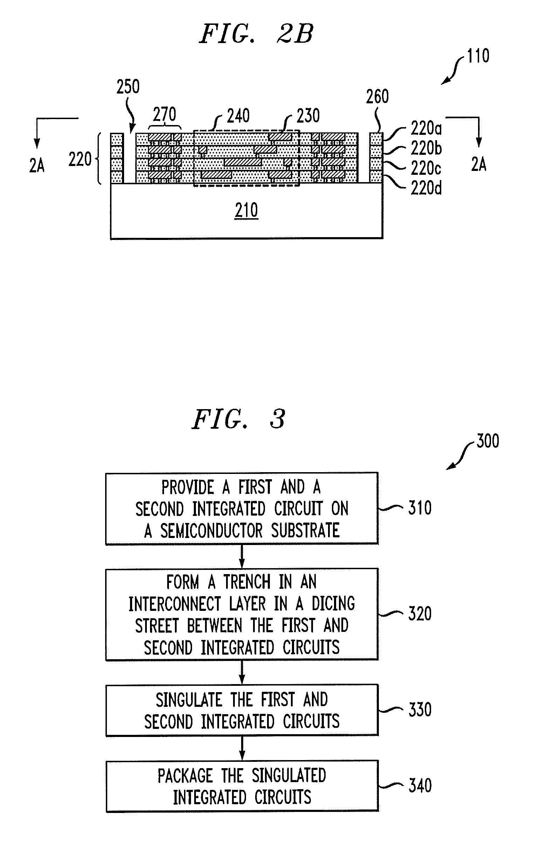

FIG. 2A illustrates a plan view of a single die 110 of the disclosure. FIG. 2B illustrates a section of the die 110 as indicated in FIG. 2A. These figures are referred to concurrently in the following description. The die 110 includes a substrate 210 and an interconnect dielectric stack 220 formed thereon. While not shown, it should be understood that the substrate may comprise a semiconductor material, such as those mentioned above regarding the wafer 100 and may also include active or passive devices, such as transistors, or capacitors or diodes, respectively. The interconnect dielectric stack 220 may be referred to briefly herein as a dielectric stack 220. As used herein and in the claims, the substrate 210 includes a portion of the wafer 100 and any overlying layers on which the dielectric stack 220 is located. The dielectric stack 220 may include, e.g., doped and undoped silicon-dioxide, low-k and ultra low-k materials, and barrier layers such as silicon nitride and silicon carbide. In a nonlimiting example, the dielectric stack 220 is illustrated as including dielectric layers 220a, 220b, 220c, 220d (FIG. 2B) which comprise the same or different dielectric materials. While shown in the embodiment of FIG. 2B as having equal thickness, in general the layers 220a, 220b, 220c, 220d will have different thicknesses.

Herein and in the claims, the term "low-k" describes a dielectric material having a relative permittivity less than that of silicon dioxide, or about 4.2. An "ultra low-k" material may have a relative permittivity less than about 3. As will be appreciated by those skilled in the pertinent art, some low-k and ultra low-k materials are mechanically more fragile than silicon dioxide, and often adhere to other layers in a dielectric stack relatively poorly as compared to, e.g., silicon dioxide. Nonlimiting examples of such materials include fluorine- or carbon-doped silicon dioxide, porous silica, and organic materials such as SiLK™.

Located within the dielectric stack 220 are interconnections 230 that may be formed conventionally. The interconnections 230 include traces, which route electrical signals and power to transistors (not shown) formed in the substrate 210 in a direction generally parallel to the substrate 210. Vias route signals between traces in a direction generally normal to the substrate 210. The interconnections 230 and the transistors are components of an integrated circuit (IC) 240. As used herein and in the claims, "interconnections" refers to the vias and traces that interconnect active devices such as transistors on the IC 240. Each dielectric layer 220a, 220b, 220c, 220d is also an interconnect dielectric layer by virtue of the presence of interconnections 230 therewithin. The dielectric stack 220 is exclusive of dielectric layers that overlie an uppermost interconnect dielectric layer, such as, e.g., a passivation overcoat (PO) layer or other environmental barrier layer.

A trench 250, the form and purpose of which are discussed below, is located within one or more of the interconnect dielectric layers 200a-220d. A remnant 260 is located between trench 250 and the die edge 255, and a seal ring 270 is located within the dielectric stack 220 and between the trench 250 and the IC 240. The seal ring 270 may be conventionally formed and may generally include stacked vias and traces located between the IC 240 and the exposed edge of the die 110. However, a seal ring 270 consisting of a single level of metal is also within the scope of the disclosure. The vias and traces are typically formed of a same metal type (e.g., copper), and simultaneously with the vias and traces of the interconnections 230. In some embodiments, the seal ring 270 is a continuous loop that completely surrounds the IC 240. In various embodiments, the seal ring 270 is not connected to any active device (such as a transistor), nor to a voltage source. The seal ring 270 may be connected to contacts that form an electrical connection to the substrate 210. Thus the seal ring 270 may be at a same electrical potential as the substrate 210.

The seal ring 270 typically acts to both reinforce the dielectric layers 220a, 220b, 220c, 220d and to prevent delamination as a result of assembly and thermal-mechanical stresses. In this sense, the seal ring 270 acts similarly to reinforcing rods in composite materials. The seal ring 270 can also act as a barrier to edge defects that might otherwise propagate into the IC 240. In various embodiments, each dielectric layer 220a, 220b, 220c, 220d includes a portion of the seal ring 270.

An edge defect may be, e.g., a crack or delamination associated with one or more of the dielectric layers 220a, 220b, 220c, 220d. A crack typically runs through a single layer, while a delamination typically runs between layers. In either case, unless stopped in some manner, an edge defect may propagate into the IC 240. While the seal ring 270 may reduce the frequency of such propagating defects, in some cases the seal ring is damaged by the propagating defect to such an extent that the defect reaches the IC 240.

However, in embodiments of the disclosure, the trench 250 may act to stop a defect that might otherwise breach the seal ring 270 and propagate into the IC 240. If a defect forms, e.g., a crack forms in the dielectric layer 220b of the remnant 260 from stress caused by the wafer saw during singulation, the defect will encounter the trench 250 before it reaches the seal ring 270. By stopping the defect, yield loss or early failure of the IC 240 that might otherwise occur due to the defect is averted.

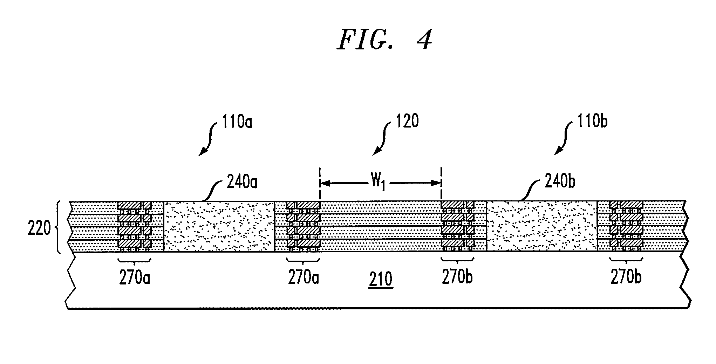

FIG. 3 illustrates a method of the disclosure. The method 300 is presented with concurrent reference to FIGs. 4-8. In a step 310, a first and a second integrated circuit, e.g. two instances of the IC 240, are provided on a semiconductor substrate, e.g., the substrate 210. The integrated circuits are separated by a dicing street that includes at least one interconnect dielectric layer. Herein, "provided" means that a device, substrate, structural element, etc., may be manufactured by the individual or business entity performing the disclosed methods, or obtained thereby from a source other than the individual or entity, including another individual or business entity.

FIG. 4 illustrates a sectional view of the dies 110a, 110b of FIG. 1. The dicing street 120 is defined as the portion of the wafer 100 and overlying layers between two seal rings 270 associated with adjacent ICs 240. Referring to FIG. 4 as an example, an IC 240a is associated with a seal ring 270a, and an IC 240b is associated with a seal ring 270b. The dicing street 120 is that portion of the wafer 100 and overlying layers located between seal rings 270a, 270b. The dicing street 120 has a width W₁ that is wide enough to accommodate, e.g., a wafer saw kerf, and may also accommodate test structures between the ICs 240a, 240b. The dielectric stack 220 is illustrated as being intact in the embodiment of FIG. 4. In some embodiments, portions of the dielectric stack 220 in the dicing street 120 have been removed, e.g., to provide alignment marks for photolithography process steps used in forming the ICs 240a, 240b.

Turning back to FIG. 3, in a step 320 a trench, e.g., the trench 250, is formed in one or more of the dielectric layers 220a, 220b, 220c, 220d in dicing street 120 between the first and second ICs 240a, 240b.

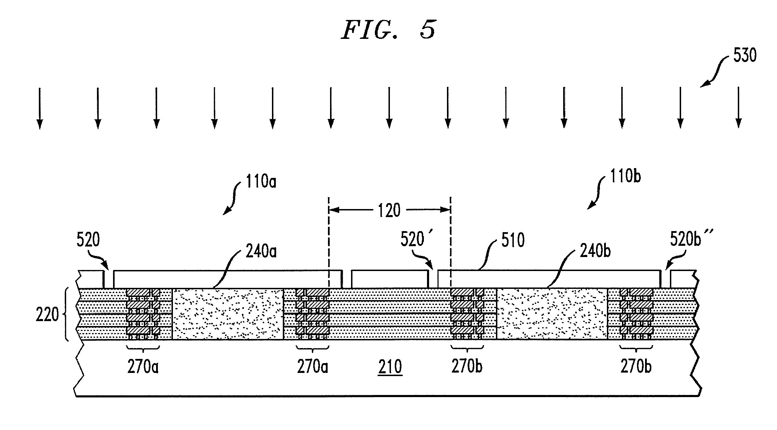

FIG. 5 illustrates an embodiment of forming the trench 250. A layer of photoresist 510 is formed conventionally over the dielectric stack 220. Openings 520 are formed conventionally in the photoresist layer 510 over locations at which the trench 250 is desired. Each opening 520 is located adjacent one of the seal rings 270, and over the dicing street 120. For example, an opening 520' is located adjacent the seal ring 270b, and over the dicing street 120. In some embodiments, the opening 520 forms a closed loop around the IC 240. Thus, e.g., the opening 520' and an opening 520" may be portions of a closed loop around the IC 240b.

An etch process 530 removes at least a portion of the dielectric stack 220 exposed by the openings 520 to form the trench 250. The etch process 530 may be a conventional or future-discovered process. In some embodiments, the etch process 530 is configured to have a high etch rate and low selectivity to the various dielectric layers 220a, 220b, 220c, 220d. For example a process similar to the Bosch process, e.g., deep reactive ion etching (DRIE), may be used. Such a process may be performed, e.g., by the Pegasus etch system available from ST Systems (USA) Inc., Redwood City, CA. Aspects of the process flow related to the etch, e.g., photoresist type, thickness, and curing, etch parameters, and post-etch clean, may be provided as a process module by process vendors such as, e.g., ST Systems.

In some embodiments, multiple etch processes may be used, each process configured to remove a particular dielectric layer. Such use of multiple processes may be desirable, e.g., in cases in which different dielectric layers have a significantly different composition, such as silicon-based vs. carbon-based. A high etch rate may be generally desirable when the total thickness of the dielectric stack 220 is significant, e.g. greater than about 1 µm. However, a slower etch rate may be used when, e.g., greater process control is desired, or to reduce plasma-induced damage to the IC 240. The etch process 530 may be timed to stop on the substrate 210 or within the dielectric stack 220. Alternatively, the etch process 530 may end-point on the substrate 210 or any intermediate layer within the dielectric stack 220.

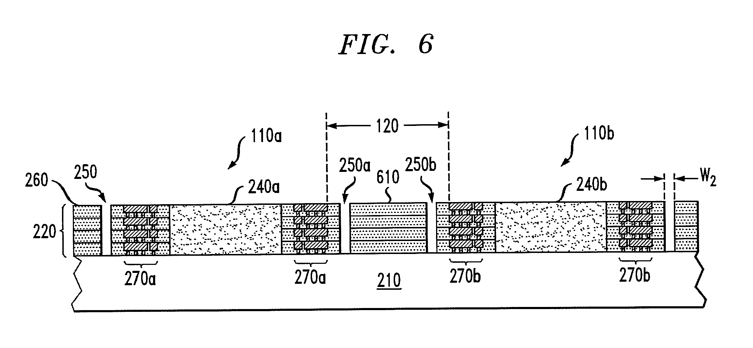

Turning now to FIG. 6, the dies 110a, 110b are shown after the etch process 530 has removed a portion of the dielectric stack 220. The removing forms trenches 250a, 250b adjacent the seal rings 270a, 270b, respectively, and a dielectric strip 610 therebetween. The dielectric strip 610 includes that portion of the dielectric stack 220 bounded by the trenches 250a, 250b. Though not shown, the dielectric strip 610 may include various structures related to, e.g., in-line testing or alignment. The trenches 250a, 250b are shown without limitation as extending to the substrate 210. In other embodiments, a portion of the dielectric stack 220 may remain above the substrate 210 within the trench 250.

In the illustrated embodiment, the etch process 530 removes substantially all the dielectric stack 220 over the substrate 210. What constitutes "substantially all" depends on the fragility of the dielectric stack 220. It is thought that greater protection against edge defects is provided by removing a greater amount of the dielectric stack 220 within the trench 250. Also, a stronger dielectric stack is generally more resistant to generation of edge defects than is a weaker dielectric stack. Thus, a dielectric stack 220 using higher-k materials is expected to be stronger than a dielectric stack 220 using lower-k materials.

In some cases, removing "substantially all" means that at least about 20% of the total thickness of the dielectric stack 220 is removed. Such cases generally include those in which the dielectric stack 220 does not include low-k or ultra low-k materials. The total thickness of the dielectric stack 220 depends upon the exact process used and the number of interconnect layers required by a particular device design. Typically, the thickness of the dielectric stack 220 falls in a range of about 2 µm to about 20 µm. Thus, for example, if the total thickness is 2 µm, the etch process 530 removes substantially all the dielectric stack 220 when the etch process 530 removes at least about 400 nm thereof.

In other cases, substantially all the dielectric stack 220 is removed when at least about 75% of the total thickness is removed. Such may be the case, e.g., when one or more of the dielectric layers 220a, 220b, 220c, 220d is formed of a relatively weaker material than in the previous case, e.g., a fluorine-doped dielectric. When particularly fragile dielectric materials are used, e.g., some ultra low-k materials such as porous silica, or an interconnect dielectric layer of concern is located near or on the substrate 210, substantially all of the dielectric stack 220 is removed when at least about 90% of the total thickness is removed.

In some embodiments, the etch process 530 may leave a thin layer of dielectric, e.g., a thermal oxide or native oxide layer over the substrate 210, and still be considered to have removed substantially all of the dielectric stack 220. In some embodiments, the etch process 530 leaves an entire or a remaining portion of one or more dielectric layers over the substrate 210, where the remaining portion is determined to present a sufficiently small risk of defect propagation. For example, a phosphorous-doped silicon dioxide layer through which substrate contacts run may be left intact, reducing the time required to form the trench 250. In still other embodiments, the etch process 530 removes a portion of the substrate 210 within the opening 520, exposing the substrate 210 and ensuring complete removal of all dielectric layers exposed by the opening 520.

A width W₂ of the trench 250 may be as wide as desired and as narrow as the etch process 530 will support. The trench 250 may be characterized by an aspect ratio, e.g., the ratio of the width of the trench 250 to the depth thereof. Conventional etch processes, e.g., a DRIE etch process, may etch a trench with an aspect ratio of at least about 30:1. Thus, e.g., when the dielectric stack 220 is 1 µm thick, W₂ may be as narrow as 30 nm while retaining the ability to expose the substrate 210 at the bottom of the trench 250.

The dicing street 120 includes two trenches 250a, 250b between the ICs 240a, 240b. In some embodiments, the trenches 250a, 250b run generally parallel to the seal rings 270. In some embodiments, the trenches 250a, 250b are unconnected. However, trenches 250a, 250b that are connected at one or more locations within the dicing street 120 are within the scope of the disclosure.

Returning to FIG. 3, in an optional step 330 the first and second integrated circuits, e.g., the ICs 240a, 240b, are singulated by a process that may be conventional.

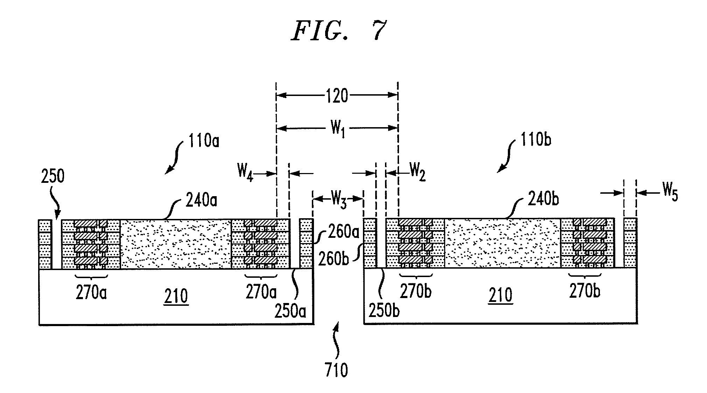

FIG. 7 illustrates the dies 110a, 110b after singulation. The dies 110a, 110b may be supported by a backing material used in the singulation process. The singulating process produces a kerf 710. Without limitation, the kerf 710 is illustrated for ease of discussion as equidistant from the seal ring 270a and the seal ring 270b. In general, the kerf 710 will be biased toward one or the other of the seal rings 270a, 270b.

The width W₁ of the dicing street 120 includes twice the width W₂ of the trench 250, a width W₃ of the kerf 710, and twice an offset W₄ from the edge of the seal ring 270 to the trench 250. FIG. 7 illustrates the specific case that the trenches 250a, 250b have equal width. Embodiments in which the trenches 250a, 250b have different widths are within the scope of the disclosure. The kerf 710 may have a width in a range of about 35 µm to about 500 µm, e.g., depending on the thickness of the saw blade used. As illustrated, a remnant 260a and a remnant 260b each have a width W₅=(W₁-2W₂-2W₄-W₃)/2. In the general case of a non-centered kerf 710, however, the remnants 260a, 260b will have unequal widths.

Conventional IC layout attempts to reduce yield loss from saw-induced fracture and delamination of interconnect dielectric layers by providing a dicing street wide enough that most defects do not propagate into or through the seal ring. The embodiments described herein offer a significant advantage over conventional IC layout by allowing integrated circuits on a wafer to be spaced closer together, allowing more IC dies to be formed on a single wafer.

It is generally preferable to select the width W₁ of the dicing street 120, the width W₂ of the trench 250, and the width W₅ of the remnant 260 such that wafer area is utilized efficiently while minimizing the production of particles. (The width W₃ of the kerf 710 is often constrained by other considerations, such as saw blade life.) If the width of the remnant 260 is too small, the remnant 260 may be more likely to break off and generate particles during or after singulation. On the other hand, if the width of the remnant 260 is too large, then available area on the wafer 100 to place the ICs 240 is unnecessarily consumed. In general an objective of die placement on the wafer is to maximize the number of complete die that may be formed on the wafer. If a reduction of the width of the remnant 260 does not result in more complete dies 110 on the wafer 100, then the area that would be saved by a smaller width of the remnant 260 may be better allocated to a larger width of the remnant 260.

An example embodiment that takes these factors into account uses a dicing street 120 width W₁ of about 50 µm and a wafer saw thickness of about 35 µm. The width W₂ of the trench 250 is about 5 µm. For a device with a dielectric stack 220 thickness of 10 µm, the aspect ratio of the trench 250 is about 2:1. The offset W₄ is about 0.5 µm. The width W₅ of the remnant 260 is then about 2.0 µm. In other embodiments, with appropriate selection of these parameters, the width W₁ may be about 40 µm and the width W₅ may be about 1 µm. These widths are expected to provide sufficient clearance and support to limit particle generation to acceptable levels while providing the benefits of the presence of the trench 250 described previously, e.g., increased die yields and reliability.

Some conventional integrated circuit designs typically call for a minimum street width of 80 µm or 120 µm to minimize defect propagation. In contrast, embodiments within the scope of the disclosure enable lowering the street width W₁ to, e.g., 50 µm or less, a reduction of about 40% to 60%. Such reduction allows an increased number of die to be placed on a production wafer. For example for a 300 mm diameter wafer that has an integrated circuit device with a die size of about 5 mm x 5 mm, a reduction of the street width from 80 µm to 50 µm increases the number of dies per wafer by about 1%. A reduction of the street width from 120 µm to 50 µm increases the number of die per wafer by about 3%. In an industry relentlessly driven to increase wafer yield, such an increase is significant and commercially valuable.

Finally, returning to FIG. 3, in an optional step 340, the singulated die 110 is mounted in and electrically connected to a device package.

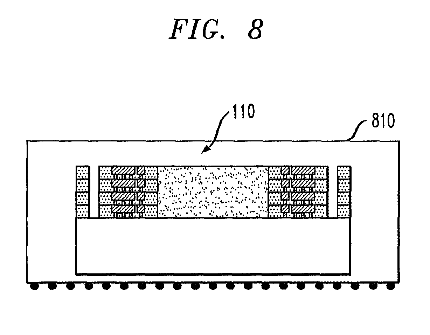

FIG. 8 illustrates a package 810 with the die 110 mounted thereto. The package 810 is shown without limitation as a ball grid array (BGA) package. The die 110 is formed according to the embodiments herein.

Those skilled in the art to which this application relates will appreciate that other and further additions, deletions, substitutions and modifications may be made to the described embodiments.

## Claims

1. A semiconductor device, comprising:
a singulated die having a substrate and a die edge;
an interconnect dielectric layer located on said substrate;
an integrated circuit having interconnections located within said interconnect dielectric layer;
a trench located in said interconnect dielectric layer;
a seal ring located within said interconnect dielectric layer and between said trench and said integrated circuit; and
a remnant of said interconnect dielectric layer located between said trench and said die edge.

2. The semiconductor device of Claim 1, wherein substantially all of said interconnect dielectric layer is removed within said trench.

3. The semiconductor device of Claim 1, wherein said substrate is exposed at a bottom of said trench.

4. The semiconductor device of Claim 1, wherein said interconnect dielectric layer includes a low-k dielectric layer.

5. A wafer having a plurality of integrated circuits formed thereover, comprising:
an interconnect dielectric layer located over said wafer;
integrated circuits having respective interconnections within said interconnect dielectric layer;
seal rings located within said dielectric layer and between said integrated circuits; and
trenches located within said interconnect dielectric layer and between said seal rings.

6. The wafer of Claim 5, wherein said wafer is exposed by said trench.

7. The wafer of Claim 5, wherein said seal ring comprises copper vias or traces.

8. A method of forming an integrated circuit die comprising:
providing a wafer having a first integrated circuit and a second integrated circuit located on a substrate, and a scribe street therebetween, said first and second integrated circuits comprising an interconnect dielectric layer, a first seal ring being located within said interconnect dielectric layer and between said first integrated circuit and said scribe street, and a second seal ring being located within said interconnect dielectric layer and between said second integrated circuit and said scribe street;
forming a first and a second trench in said interconnect dielectric layer such that said first seal ring is located between said first trench and said first integrated circuit, said second seal ring is located between said second trench and said second integrated circuit, and a dielectric strip is located between said first trench and said second trench.

9. The method of Claim 8, further comprising singulating said first and second integrated circuits, thereby forming a die edge and a remnant of said interconnect dielectric layer, such that said remnant is located between said die edge and said first trench.

10. The method of Claim 8, wherein forming said first and second trenches exposes said substrate.
